(19) Europäisches Patentamt
European Patent Office
Office européen des brevets

(11) **EP 4 310 473 A1**

(12) **EUROPEAN PATENT APPLICATION**

(43) Date of publication:
**24.01.2024 Bulletin 2024/04**

(21) Application number: **23180597.9**

(22) Date of filing: **21.06.2023**

(51) International Patent Classification (IPC):
**G01K 11/24** (2006.01)    **H04M 1/72403** (2021.01)

(52) Cooperative Patent Classification (CPC):
**G01K 11/24; H04M 1/72403**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.07.2022 US 202263390247 P**
**20.04.2023 US 202318304197**

(71) Applicant: **Apple Inc.**
**Cupertino, CA 95014 (US)**

(72) Inventors:
• **VUMMIDI MURALI, Krishna Prasad**
**Cupertino, 95014 (US)**

• **GILL, Patrick R.**
**Cupertino, 95014 (US)**
• **MUDIVARTHI, Chaitanya**
**Cupertino, 95014 (US)**
• **RIBEIRO, Roberto M.**
**95014 Cupertino (UM)**
• **SHINWARI, Mohammad Waleed**
**Cupertino, 95014 (US)**
• **POP, Flavius**
**Cupertino, 95014 (US)**
• **LEHR, Michael A.**
**Cupertino, 95014 (US)**

(74) Representative: **Zacco Denmark A/S**
**Arne Jacobsens Allé 15**
**2300 Copenhagen S (DK)**

(54) **ELECTRONIC DEVICES WITH ULTRASONIC TEMPERATURE SENSORS**

(57)    An electronic device may include one or more ultrasonic temperature sensors. The ultrasonic temperature sensors may be formed in openings or cavities in a housing of the electronic device. The ultrasonic temperature sensors may include ultrasonic transmitters that transmit signals at different ultrasonic frequencies and ultrasonic receivers that receive the transmitted signals. Phase differences between the received ultrasonic signals may be used to determine the speed of sound of ambient air and therefore calculate the temperature of the ambient air. The ultrasonic transmitters and receivers may include piezoelectric micromachined ultrasound transducers (PMUTs). Each transmitter and receiver may be a dedicated transmitter or receiver, or may transmit and receive ultrasonic signals. Each receiver may include an array of PMUTs that receive ultrasonic signals of different frequencies. The PMUTS may be formed on complementary metal-oxide semiconductors (CMOS).

*FIG. 1*

**Description**

<u>Field</u>

This relates generally to electronic devices, and, more particularly, to electronic devices with environmental sensors.

**Background**

Electronic devices such as laptop computers, cellular telephone, and other equipment are sometimes provided with environmental sensors, such as ambient light sensors, image sensors, and microphones. However, it may be difficult to incorporate some environmental sensors into an electronic device where space is at a premium.

**Summary**

An electronic device may be provided with a housing and a temperature sensor in the housing. The temperature sensor may be an ultrasonic temperature sensor, and may include multiple ultrasonic transmitters and receivers. The ultrasonic transmitters and receivers may be dedicated to transmitting or receiving, or may perform both functions. The ultrasonic transmitters and receivers may each include an array of piezoelectric micromachined ultrasound transducers (PMUTs) that emit and are sensitive to different ultrasonic frequencies. In operation, the ultrasonic transmitters may emit signals with different ultrasonic frequencies, and the ultrasonic receivers may receive those signals.

Control circuitry may determine an ambient temperature based on a phase difference between the received ultrasonic signals. In particular, the phase difference between the received ultrasonic signals may be related to the speed of sound through the ambient air, which is proportional to the ambient temperature because the density of air changes with respect to the temperature.

The temperature sensor may be formed in a cavity or opening within the housing, and may be covered with a mesh or grille, if desired. The temperature sensor may include any desired number of transmitters and receivers (e.g., arrays of PMUTs), and may have dedicated ultrasonic transmitters and receivers or may have PMUTS that both transmit and receive ultrasonic signals. Each PMUT may be formed on a complementary metal-oxide semiconductor (CMOS).

**Brief Description of the Drawings**

FIG. 1 is a drawing of an illustrative wearable electronic device in accordance with an embodiment.

FIG. 2 is a drawing of an illustrative portable device in accordance with an embodiment.

FIG. 3 is a diagram of an illustrative electronic device in accordance with an embodiment.

FIG. 4A is a side view of an illustrative electronic device having a temperature sensor in a cavity of a housing in accordance with an embodiment.

FIG. 4B is a side view of an illustrative electronic device having a temperature sensor with transmitting and receiving components in separate cavities of a housing in accordance with an embodiment.

FIG. 5 is a graph of an illustrative relationship between temperature and a measured speed of sound in accordance with an embodiment.

FIG. 6 is a graph of an illustrative relationship between air density/atmospheric pressure and altitude in accordance with an embodiment.

FIG. 7 is a diagram of an illustrative ultrasonic temperature sensor having a transmitter and a receiver in accordance with an embodiment.

FIG. 8A is a graph of an illustrative relationship between multiple transmit frequencies and phase (the number of periods elapsed between transmitters and receivers) in an ultrasonic temperature sensor in accordance with an embodiment.

FIG. 8B is a graph of an illustrative relationship between multiple transmit frequencies and phase difference in an ultrasonic temperature sensor in accordance with an embodiment.

FIG. 9 is a diagram of an illustrative ultrasonic temperature sensor having multiple transmitters and receivers in accordance with an embodiment.

FIG. 10 is a graph of an illustrative relationship between temperature and phase difference measured by an ultrasonic temperature in accordance with an embodiment.

FIG. 11 is a top view of an illustrative array of piezoelectric micromachined ultrasonic transducers that may be used in an ultrasonic temperature sensor in accordance with an embodiment.

FIG. 12 is a side view of an illustrative piezoelectric micromachined ultrasonic transducer that may be used in an ultrasonic temperature sensor in accordance with an embodiment.

FIG. 13 is a flowchart of illustrative steps used in determining an ambient temperature using an ultrasonic temperature sensor in accordance with an embodiment.

## Detailed Description

Electronic devices are often carried by users as they conduct their daily activities. For example, a user may carry an electronic device on their person throughout the day while walking, commuting, working, exercising, etc. In some situations, it may be desirable for the user to know the ambient temperature of the air, or the temperature of another environmental medium (e.g., water). Although electronic devices may receive information regarding ambient temperature and weather conditions through various online resources, this information may not be accurate for the user's exact location, such as shaded areas (e.g., under a tree or on a shaded trail) or on surfaces that may affect the ambient temperature (e.g., grass or asphalt). Therefore, one or more temperature sensors may be incorporated into the electronic devices to measure environmental temperature directly.

The temperature sensors may be ultrasonic temperature sensors that determine the speed of sound through the ambient air (or through another surrounding medium). The speed of sound may then be used to determine the temperature of the air or other surrounding medium. In this way, temperature sensors within an electronic device may make accurate temperature measurements of the environment surrounding the user.

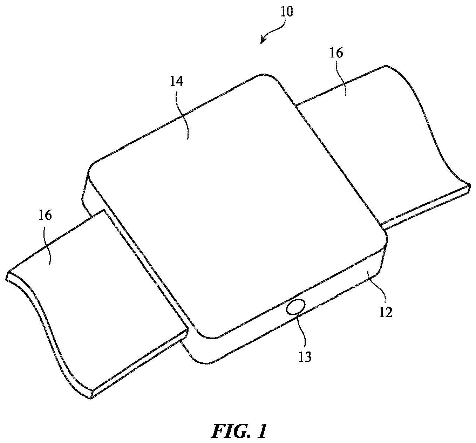

In general, any suitable electronic devices may include temperature sensors. As shown in FIG. 1, a wearable electronic device 10, which may be a wristwatch device, may have a housing 12, a display 14, and a strap 16. The wristwatch may attach to a user's wrist via strap 16. One or more temperature sensors may be incorporated into housing 12. For example, housing 12 may have an opening or cavity 13. A temperature sensor may be formed within opening or cavity 13. In particular, opening or cavity 13 may allow ambient air to reach the temperature sensor, which may then determine the temperature of the ambient air. In some embodiments, opening or cavity 13 may be covered by a mesh, grille, or other covering that allows air to pass through unimpeded.

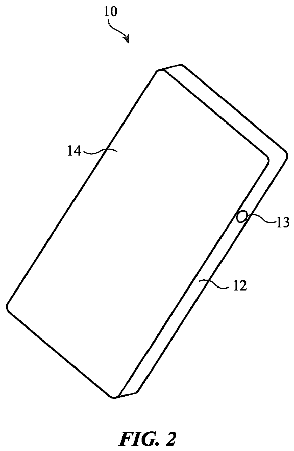

Another illustrative device that may include one or more temperature sensors is shown in FIG. 2. As shown in FIG. 2, a portable device 10, which may be a cellular telephone, a tablet computer, or other portable device, for example, has housing 12 and display 14. One or more temperature sensors may be incorporated into housing 12 within opening or cavity 13.

Although opening or cavity 13 is shown on a sidewall of housing 12 in FIGS. 1 and 2 (i.e., between a front face of housing 12 that has display 14 and an opposing rear face of housing 12), this is merely illustrative. In general, a temperature sensor may be formed anywhere in device, such as on a front face of device 10 (with display 14) and/or on a rear face of device 10 (opposite display 14).

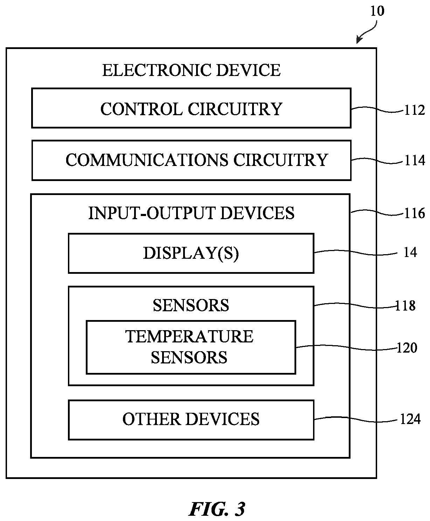

Although FIGS. 1 and 2 show electronic device 10 shown as a wristwatch device and/or a cellular telephone device, these examples are merely illustrative. In general, electronic device 10 may be any desired device, such as a media player, or other handheld or portable electronic device, a wristband device, a pendant device, a headphone, a speaker, a smart speaker, an ear bud or earpiece device, a head-mounted device such as glasses, goggles, a helmet, or other equipment worn on a user's head, or other wearable or miniature device, a navigation device, or other accessory, and/or equipment that implements the functionality of two or more of these devices. Illustrative configurations in which electronic device 10 is a portable electronic device such as a cellular telephone, wristwatch, or portable computer may sometimes be described herein as an example. Regardless of the form factor of device 10, an illustrative schematic diagram of device 10 is shown in FIG. 3.

As shown in FIG. 3, electronic devices such as electronic device 10 may have control circuitry 112. Control circuitry 112 may include storage and processing circuitry for controlling the operation of device 10. Circuitry 112 may include storage such as hard disk drive storage, nonvolatile memory (e.g., electrically-programmable-read-only memory configured to form a solid-state drive), volatile memory (e.g., static or dynamic random-access-memory), etc. Processing circuitry in control circuitry 112 may be based on one or more microprocessors, microcontrollers, digital signal processors, baseband processors, power management units, audio chips, graphics processing units, application specific integrated circuits, and other integrated circuits. Software code may be stored on storage in circuitry 112 and run on processing circuitry in circuitry 112 to implement control operations for device 10 (e.g., data gathering operations, operations involving the adjustment of the components of device 10 using control signals, etc.).

Electronic device 10 may include communications circuitry 114, which may include wired and/or wireless communications circuitry. For example, electronic device 10 may include radio-frequency transceiver circuitry, such as cellular telephone transceiver circuitry, wireless local area network transceiver circuitry (e.g., WiFi® circuitry), short-range radio-frequency transceiver circuitry that communicates over short distances using ultra high frequency radio waves (e.g., Bluetooth® circuitry operating at 2.4 GHz or other short-range transceiver circuitry), millimeter wave transceiver circuitry, and/or other wireless communications circuitry.

Device 10 may include input-output devices 116. Input-output devices 116 may be used to allow a user to provide device 10 with user input. Input-output devices 116 may also be used to gather information on the environment in which device 10 is operating. Output components in devices 116 may allow device 10 to provide a user with output and may be used to communicate with external electrical equipment.

Input-output devices 116 may include one or more optional displays such as displays 14. Displays 14 may be organic light-emitting diode displays or other displays with light-emitting diodes, liquid crystal displays, microLED displays, or other displays. Displays 14 may be touch sensitive (e.g., displays 14 may include two-dimensional touch sensors for capturing touch input from a user) and/or displays 14 may be insensitive to touch.

Input-output devices 116 may include sensors 118. Sensors 118 may include, for example, three-dimensional sensors (e.g., three-dimensional image sensors such as structured light sensors that emit beams of light and that use two-dimensional digital image sensors to gather image data for three-dimensional images from light spots that are produced when a target is illuminated by the beams of light, binocular three-dimensional image sensors that gather three-dimensional images using two or more cameras in a binocular imaging arrangement, three-dimensional lidar (light detection and ranging) sensors, three-dimensional radio-frequency sensors, or other sensors that gather three-dimensional image data), cameras (e.g., infrared and/or visible digital image sensors), gaze tracking sensors (e.g., a gaze tracking system based on an image sensor and, if desired, a light source that emits one or more beams of light that are tracked using the image sensor after reflecting from a user's eyes), touch sensors, capacitive proximity sensors, light-based (optical) proximity sensors, other proximity sensors, force sensors, sensors such as contact sensors based on switches, gas sensors, pressure sensors, moisture sensors, magnetic sensors (e.g., a magnetometer), audio sensors (microphones), ambient light sensors, microphones for gathering voice commands and other audio input, sensors that are configured to gather information on motion, position, and/or orientation (e.g., accelerometers, gyroscopes, pressure sensors, compasses, and/or inertial measurement units that include all of these sensors or a subset of one or two of these sensors), health sensors that measure various biometric information (e.g., heartrate sensors, such as a photoplethysmography sensor), electrocardiogram sensors, and perspiration sensors) and/or other sensors.

Sensors 118 may also include one or more temperature sensors 120. Temperature sensors 120 may be, for example, ultrasonic sensors that measure the speed of sound through ambient air. In particular, temperature sensors 120 may include one or more ultrasonic transmitters and one or more ultrasonic receivers. The ultrasonic transmitters may emit signals with different ultrasonic frequencies, and the ultrasonic receivers may receive the emitted signals. Control circuitry in device 10, such as control circuitry 112, may determine a phase difference between the signals received by the ultrasonic receivers, which may be used to determine the ambient temperature.

If desired, input-output devices 116 may include other devices 124 such as haptic output devices (e.g., vibrating components), light-emitting diodes and other light sources, speakers such as ear speakers for producing audio output, circuits for receiving wireless power, circuits for transmitting power wirelessly to other devices, batteries and other energy storage devices (e.g., capacitors), joysticks, buttons, and/or other components.

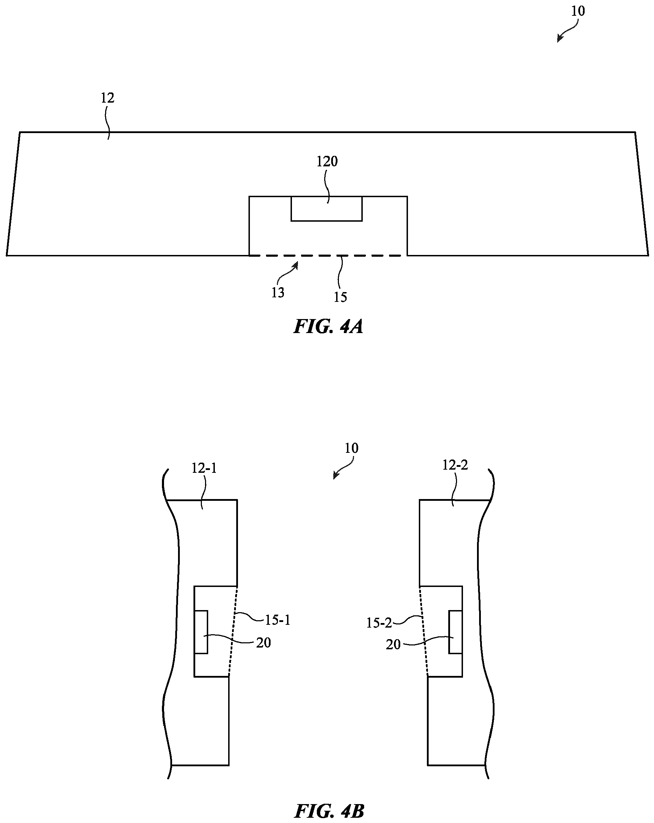

To accommodate sensors in device 10, such as temperature sensors 120, it may be desirable to have openings or cavities in the housing of device 10. An example of an opening or cavity that may be incorporated into a device housing is shown in FIG. 4A.

As shown in FIG. 4A, housing 12 of device 10 may include opening/cavity 13. Cavity 13 may be a recessed portion of housing 12 (i.e., cavity 30 extend partially through housing 12), as shown in FIG. 4A. Alternatively, opening 13 may extend entirely through housing 12. Regardless of whether cavity/opening 13 extends partially or entirely through housing 12, a temperature sensor, such as temperature sensor 120, may be formed within cavity/opening 13. Temperature sensor 120 may be, for example, an ultrasonic temperature sensor.

If desired, opening/cavity 13 and temperature sensor 120 may be covered. As shown in FIG. 4A, optional mesh 15 may cover temperature sensor 120. Openings within mesh 15 may allow ambient air to reach temperature sensor 120 so temperature sensor 120 can determine the temperature of the ambient air. Mesh 15 may be a passive low-pass acoustic filter that allows ambient air to reach temperature sensor 120. While FIG. 4 shows mesh 15 covering temperature sensor 120, any desired material, such as a grille or other material that allows air to pass through unimpeded, may cover temperature sensor 120.

In some examples, it may be desirable to increase the amount of air that circulates and reaches temperature sensor 120. Therefore, temperature sensor 120 may be formed in opening/cavity 13 with a speaker, fan, pump, or other component that can circulate air into cavity 13. In this way, temperature sensor 120 may obtain accurate measurements of ambient air temperature.

Generally, any number of openings and/or cavities may be formed in housing 12, and electronic device 10 may include any desired number of temperatures sensors. One or more temperature sensors and associated openings/cavities may be formed on a front face, rear face, and/or sidewalls of device 10. Additionally, although FIG. 4A has shown a single temperature sensor in a single cavity, a temperature sensor may have a transmitter and receiver that are formed in separate cavities. An example of this arrangement is shown in FIG. 4B.

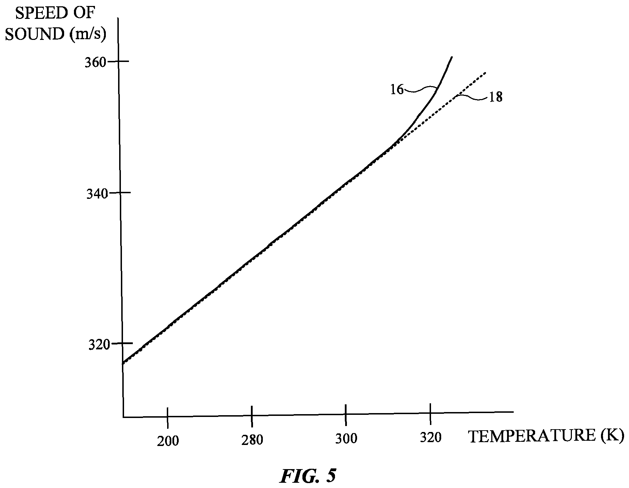

As shown in FIG. 4B, housing 12 may have two housing portions, 12-1 and 12-2. There may be individual cavities in each housing portion, which may be covered by acoustic filters 15-1 and 15-2, respectively. Ultrasonic transmitter 20 may be formed in the cavity in housing portion 12-1, while ultrasonic receiver 22 may be formed in housing portion 12-2. However, the positioning of temperature sensor 120 (or portions of temperature sensor 120, such as ultrasonic transmitter 20 and ultrasonic receiver 22) in a cavity or cavities in housing 12 is merely illustrative. In some examples, a temperature sensor may include an ultrasonic transmitter and receiver, and one or both of the ultrasonic transmitter and ultrasonic receiver may be positioned on an exterior surface of device 10 (e.g., on an external surface of housing 12). Regardless of where temperature sensors are included in device 10, they may be ultrasonic temperature sensors that measure the temperature of the ambient air through the association between ambient temperature and the speed of sound through the air. An illustrative relationship between the speed of sound and temperature is shown in FIG. 5.

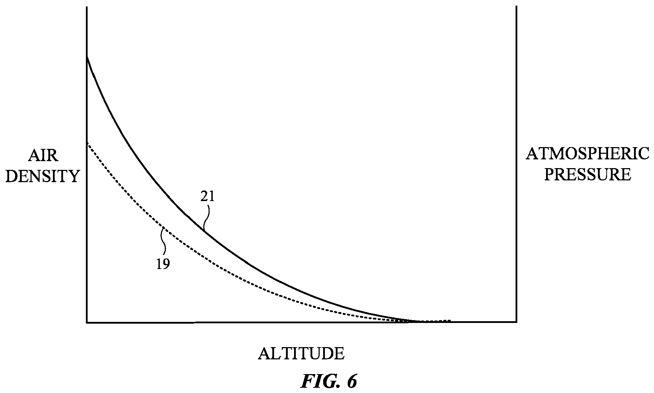

Curves 16 and 18 of FIG. 5 are illustrative relationships between the speed of sound (m/s) in air and the temperature (K) of the air at 100% humidity and 0% humidity, respectively. As shown by curve 18, at 0% humidity, there is a linear (or substantially linear) relationship between temperature and the speed of sound from 250K to 330K. Although this linear relationship does not hold at 100% humidity for high temperatures (e.g., over 315 K), the relationship is linear for most of temperature range. If desired, the divergence at higher temperatures may be accounted for by an approximation of humidity from an online weather service. Alternatively or additionally, electronic device 10 may include pressure sensors and/or humidity sensors to determine ambient humidity, which control circuitry in device 10 may then use to correct the ambient temperature measurement. An example of compensation for differences in air density/atmospheric pressure is shown in FIG. 6.

Curve 19 of FIG. 6 is an illustrative relationship between air density and altitude, while curve 21 of FIG. 6 is an illustrative relationship between atmospheric pressure and altitude. As shown in FIG. 6, both curve 19 and curve 21 decrease with increasing altitude. Therefore, as electronic device 10 is taken to higher altitudes, the air density and atmospheric pressure will decrease, affecting the speed of sound through the air. In particular, at higher altitudes, the air density will be lower, so the speed of sound through the air will be lower at typical humidity levels. To compensate for this change, a pressure sensor in device 10 may be used to measure the atmospheric pressure (or other sensors within device 10 may be used to determine the atmospheric pressure/altitude), which may be related to altitude and air density as shown in FIG. 6. Once the air density is known, control circuitry in device 10 may correct the ambient temperature measurement that is based on the speed of sound per FIG. 5. For example, if device 10 is at a high altitude, the control circuitry may correct the ambient temperature measurement upward to compensate for the decreased speed of sound through the less dense air per the relationships in FIGS. 5 and 6.

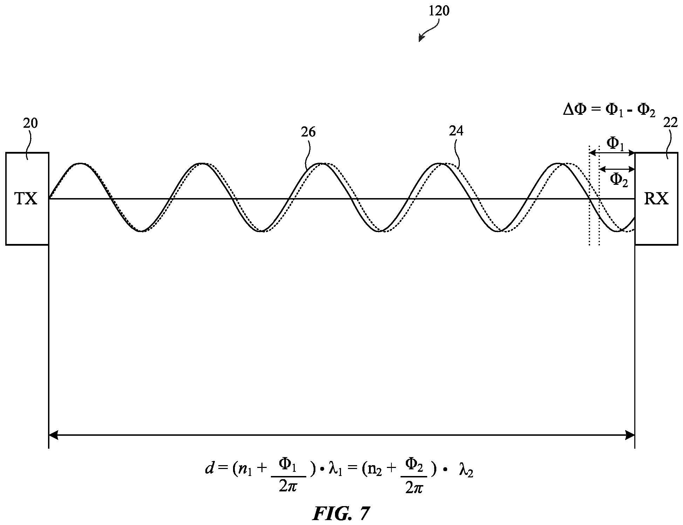

Therefore, a temperature sensor, such as temperature sensor 120, may determine ambient temperature through the relationship with the speed of sound through ambient air. An illustrative ultrasonic temperature sensor that may determine ambient temperature from the speed of sound is shown in FIG. 7.

As shown in FIG. 7, a temperature sensor, such as temperature sensor 120, may include ultrasonic transmitter 20 and ultrasonic receiver 22. Ultrasonic transmitter 20 may emit one or more ultrasonic frequencies between 1 MHz and 3 MHz. As shown in FIG. 7, ultrasonic transmitter 20 may emit first signal 24 and second signal 26. First signal 24 and second signal 26 may have different ultrasonic frequencies. First signal 24 may have a frequency of at least 1 MHz, at least 1.2 MHz, or at least 1.23 MHz, as examples. Second signal 26 may have a frequency between 2 MHz and 3 MHz, or other desired frequency. Generally, first signal 24 and second signal 26 may have any desired ultrasonic frequencies.

Ultrasonic receiver 22 may be separated from ultrasonic transmitter 20 by distance d and may detect first signal 24 and second signal 26 when they reach ultrasonic receiver 22. Transmitter 20 and receiver 22 may be separated by any desired distance d, such as by less than 20 mm, by less than 15 mm, by between 10 mm and 15 mm, or by less than 10 mm. Generally, the speed of sound may be determined from distance d, the frequency emitted by ultrasonic transmitter 20, and the number of wavelengths (i.e., the number of periods) between ultrasonic transmitter 20 and ultrasonic receiver 22. However, the number of periods between ultrasonic transmitter 20 and ultrasonic receiver 22 may be difficult to measure directly. Therefore, the phase difference $\Delta\varphi$ between first signal 24 and second signal 26 may be used to determine the speed of sound.

In particular, distance d may be related to the number of waves n by Equation 1,

$$d = \left(n_1 + \frac{\varphi_1}{2\pi}\right)\lambda_1 = \left(n_2 + \frac{\varphi_2}{2\pi}\right)\lambda_2 \qquad (1)$$

where $\lambda$ is the wavelength of the signal emitted by transmitter 20 and $\varphi$ is the phase change in radians of the corresponding signal at receiver 22. Using Equation 1, the relation between the speed of sound and ambient temperature, the relation of the speed of sound and the number of wavelengths through a given distance at a given frequency, and the known parameters of signals 24 and 26 (e.g., the frequencies of the signals), the difference in phase $\varphi$ between signals 24 and 26 may be related to the ambient temperature. In this way, ultrasonic temperature sensor 120 may be used to determine the ambient temperature.

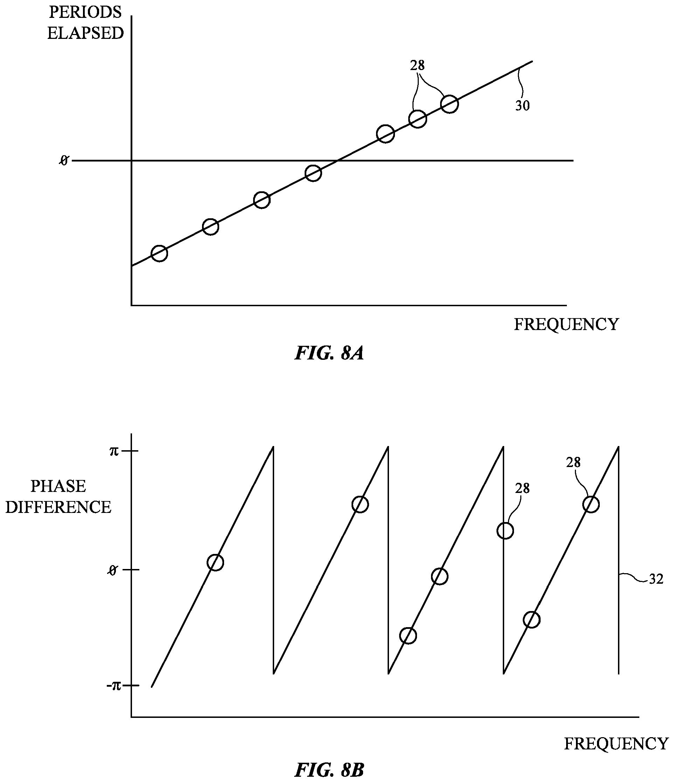

Although FIG. 7 shows a single ultrasonic transmitter emitting two signals of different ultrasonic frequencies and a single ultrasonic receiver, this is merely illustrative. In general, a temperature sensor may include any desired number of ultrasonic transmitters and receivers. Additionally, a temperature sensor may emit and detect any desired number of ultrasonic signals at different frequencies. Illustrative graphs showing the number of periods elapsed and phase difference for multiple frequencies are shown in FIGS. 8A and 8B.

As shown in FIG. 8A, multiple signals may be emitted by an ultrasonic transmitter, such as transmitter 20. The transmitted signals may be pulsed or continuous, and the different frequencies may be emitted simultaneously or sequentially. Each signal may be emitted at a different frequency, such as a frequency between 1 MHz and 3 MHz. Due to the different frequencies, each signal may take a different number of periods (i.e., wavelengths) to reach an ultrasonic receiver. Each signal is denoted by one of points 28 of FIG. 8A. As shown, higher frequency signals may take more periods to reach the ultrasonic receiver, while lower frequency signals may take fewer periods to reach the ultrasonic receiver. The relationship between frequency and periods elapsed between transmission and reception may be given by line (or curve) 30.

Although the speed of sound (and therefore the ambient temperature) could be determined from the number of periods elapsed between transmission and reception, this may be difficult to measure directly. Instead, a phase difference between each received signal may be determined. An illustrative relationship between frequency and phase difference is shown in FIG. 8B.

As shown in FIG. 8B, the phase difference between the transmission and reception at each frequency may be plotted for each signal 28. A relationship between these phase differences may be found. In particular, a curve, such as curve 32, may be fit to each point (corresponding to each signal 28). Curve 32 may provide best fit (or other desired) function between frequency and phase difference. After obtaining curve 32, the speed of sound may be calculated from a system of equations, including Equation 1 for each frequency, the relation of the speed of sound and the number of wavelengths in a given distance at a given frequency, and the known parameters of the ultrasonic signals. In this way, the ambient temperature may be measured.

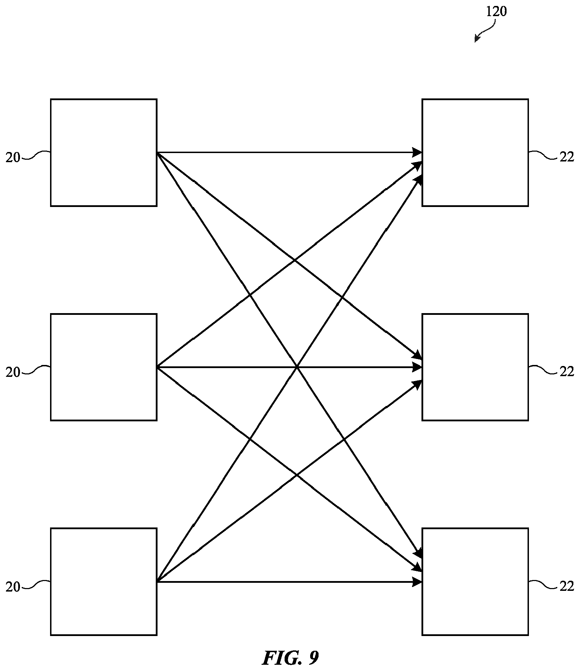

As previously discussed, an ultrasonic transmitter may emit multiple ultrasonic frequencies that may then be received by an ultrasonic receiver. In some embodiments, it may be desirable to have multiple ultrasonic transmitters that each emit signals one or more ultrasonic frequencies and multiple ultrasonic receivers that receive the signals. An example of a temperature sensor having multiple ultrasonic transmitters and multiple ultrasonic receivers is shown in FIG. 9.

As shown in FIG. 9, temperature sensor 120 may include multiple ultrasonic transmitters 20 and multiple ultrasonic receivers 22. Each ultrasonic transmitter 20 may emit multiple signals, which may be detected by ultrasonic receivers 22, as indicated by the lines from each ultrasonic transmitter 20. If desired, each ultrasonic transmitter 20 may include an array of individual ultrasonic transmitters, and each ultrasonic receiver 22 may include an array of individual ultrasonic receivers. In some examples, each ultrasonic transmitters 20 (e.g., an array of ultrasonic transmitters) may emit multiple signals at the same frequency, or may emit multiple signals at different frequencies. Alternatively or additionally, each ultrasonic transmitter 20 (e.g., an array of ultrasonic transmitters) may emit signals at different frequencies. In this way, signals with different frequencies may be emitted and detected, allowing for a phase difference to between the detected signals to be determined and an ambient temperature calculated.

The example of FIG. 9 shows an arrangement of three arrays of ultrasonic transmitters and three arrays of ultrasonic receivers in a temperature sensor. However, this is merely illustrative. Any number of desired ultrasonic transmitters and receivers may be used. For example, a temperature sensor may have five arrays of ultrasonic transmitters and five arrays of ultrasonic receivers, one ultrasonic transmitter and one ultrasonic receiver, or any other desired number of transmitters and receivers. All of the transmitters may be formed in a shared plane and all of the receivers may be formed in a shared plane, or the components may be formed in different planes. The transmitters and receivers may face each other, or may be next to each other. If desired, the transmitters may be formed on a first shared semiconductor die, and the receivers may be formed on a second shared semiconductor die. Alternatively, the transmitters and receivers may be formed on a single semiconductor die. In some examples, a temperature sensor may have different numbers of transmitters and receivers, such as having three transmitters and five receivers.

By having multiple arrays of ultrasonic transmitters, multiple times of flight may be measured for the same frequency. To detect 0.5°C changes in temperature, an ultrasonic temperature sensor may need to measure speed of sound changes of 1 part in 1000. Additionally, mechanical variations of 1 part in 1000 (10 microns for a 1 cm gap) may be difficult to avoid. Using multiple ultrasonic transmitters 20, which each may include an array of individual transmitters, and multiple ultrasonic receivers 22, which each may include an array of individual receivers, the speed of sound and temperature sensor geometry changes may be disambiguated. For example, with five arrays of transmitters and five arrays of receivers, 25 measurements of time-of-flight may be made.

Regardless of the number of transmitters and receivers incorporated into a temperature sensor, some of the transmitters and/or receivers may be selectively deactivated and activated as desired. For example, a temperature sensor may save power by using fewer than all of the transmitters and/or receivers during some measurements. However, this is merely illustrative. In general, all of the transmitters and receivers may be used for all temperature measurements, if desired.

Although temperature sensors have been described as having ultrasonic transmitters, such as ultrasonic transmitters 20, and ultrasonic receivers, such as ultrasonic receivers 22, temperature sensors may be ultrasonic components that both transmit and receive signals, if desired. For example, in the example of FIG. 9, components 20 may transmit ultrasonic signals and components 22 may receive those signals during some measurements, while components 22 may transmit ultrasonic signals and components 20 may receive those signals during other measurements. In other words, the directionality of transmission and reception shown in FIG. 9 may be reversed in some embodiments.

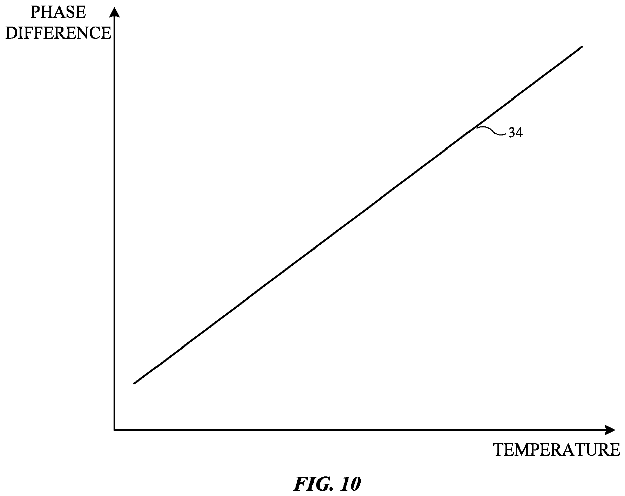

Alternatively or additionally, ultrasonic components may be used for both transmission and reception during the same measurement, if desired. For example, components 20 may emit ultrasonic signals, which may reflect off of a known surface, such as housing 12 or other surface in cavity/opening 13 (FIG. 4), and components 20 may detect the reflected signals. In general, any desired arrangement of ultrasonic components may be used to emit and detect ultrasonic signals with different frequencies to determine a phase difference between the detected signals. The phase difference may then be used to determine ambient temperature. An illustrative relationship between the phase difference of received ultrasonic signals and ambient temperature is shown in FIG. 10.

As shown in FIG. 10, illustrative relationship 34 between ambient temperature and the phase difference $\Delta\varphi$ may be established. In particular, by emitting multiple ultrasonic frequencies and determining the phase difference between those frequencies when they are detected, the ambient temperature may be determined. In this way, an ultrasonic temperature sensor may determine ambient temperature by emitting and detecting multiple signals with different ultrasonic frequencies.

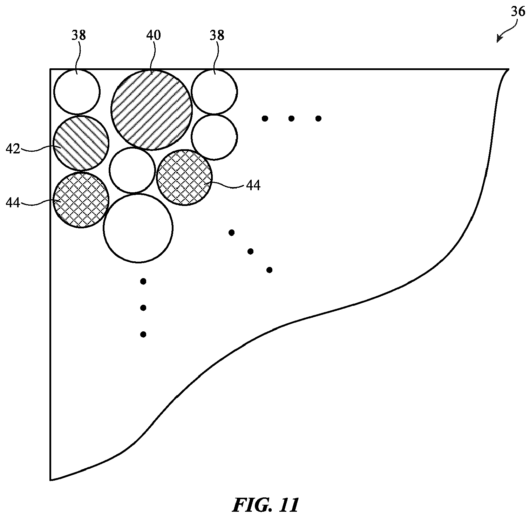

Ultrasonic transmitters, such as ultrasonic transmitters 20, and ultrasonic receivers, such as ultrasonic receivers 22, may be formed from one or more micro-electromechanical system (MEMS) sensors, such as piezoelectric micromachined ultrasonic transducers (PMLTTs). For example, ultrasonic components within a temperature sensor may include one or more arrays of PMLTTs. An example of an ultrasonic component that includes an array of PMLTTs is shown in FIG. 11.

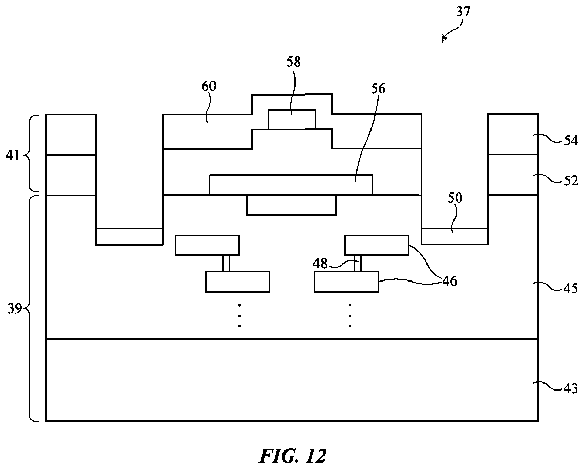

As shown in FIG. 11, ultrasonic component 36 may include an array of PMLTTs. Ultrasonic component 36 may be an ultrasonic transmitter (such as ultrasonic transmitter 20), an ultrasonic receiver (such as ultrasonic receiver 22), or an ultrasonic component that both transmits and receives ultrasonic signals. Ultrasonic component 36 may include PMUTs 38, 40, 42, and 44, which each may transmit and/or receive ultrasonic signals of different frequencies. PMLTTs 38, 40, 42, and 44 may enable ultrasonic component 36 to emit different frequencies, or receive different frequencies that are emitted by a different ultrasonic component or by ultrasonic component 36. Each PMLTT 38, 40, 42, and 44 may emit and/or receive a dedicated ultrasonic frequency between 1 MHz and 3 MHz, or may be tunable to emit and/or receive any desired frequency. Each PMLJT 38, 40, 42, and 44 may be formed on a complementary metal-oxide semiconductor (CMOS). An embodiment in which a PMUT is formed on a CMOS is shown in FIG. 12.

As shown in FIG. 12, PMUT 41 may be formed on CMOS 39. CMOS 39 may include substrate 43, which may be a semiconductor substrate, such as silicon. A plurality of metal layers 46 interconnected by vias 48 may be formed in layer 45 on substrate 43. Layer 45 may be formed from silicon dioxide or other desired material. Bond pads 50 may be formed on the top surface of layer 45, and may be formed from any desired metal.

PMUT 41 may be formed on top of CMOS 39 and, more specifically, on top of layer 45. In particular, metal layer 56 may be formed on top of layer 45. Metal layer 46 may be aluminum or another desired metal. Layer 52 may be formed over metal layer 46, and may include a nitride, such as aluminum nitride or gallium nitride. Alternatively, other materials, such as lithium niobate, may be used to form layer 52.

Another metal layer 58 may be formed on layer 52. Metal layer 58 may be formed from aluminum or another desired metal. In some embodiments, it may be desirable to form metal layer 58 from the same metal as metal layer 56.

Upper layer 60 may overlap metal layer 58 (and also have portion 54 that overlaps layer 52). Upper layer 60 may be formed from silicon dioxide, silicon nitride, or another desired material.

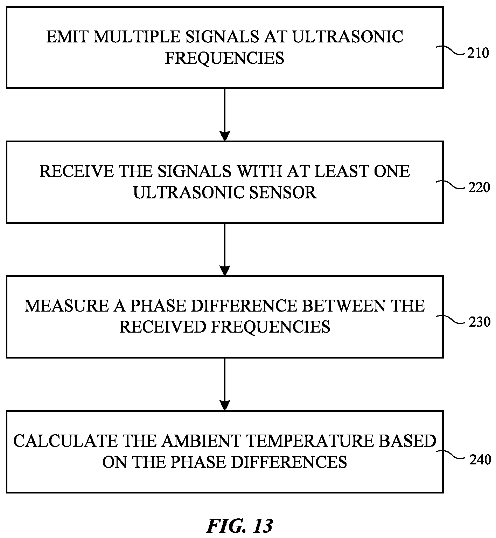

In general, PMLTT 41 may be formed on a standard CMOS, and may include one or more metal layers that are used by circuitry within an electronic device to transmit and/or receive desired ultrasonic frequencies. A flowchart with illustrative steps of operating a temperature sensor, such as a temperature sensor that includes one or more PMLTTs 41, is shown in FIG. 13.

As shown in FIG. 13, at step 210, a transmitter, such as ultrasonic transmitter 20, may emit multiple signals at ultrasonic frequencies. In general, any desired number of transmitters may be used to emit any desired number of signals of different frequencies. In some examples, one, three, or five transmitters may be used to emit two, three, or five different ultrasonic frequencies. The ultrasonic frequencies may be between 1 MHz and 3 MHz, as an example.

At step 220, a sensor, such as ultrasonic receiver 22, may receive the signals. The sensor may include one or more ultrasonic receivers, such as three receivers or five receivers, as examples. In some embodiments, the ultrasonic receivers may also transmit ultrasonic frequencies, or the ultrasonic receivers may be dedicated receivers.

At step 230, the temperature sensor or control circuitry within device 10 may measure a phase difference between the received signals. In particular, because the received signals have different frequencies, they will have traveled a different number of wavelengths (periods) between the transmitter and receiver. Although the number of periods traveled by each signal cannot be measured directly, the receivers or control circuitry may determine the phase of the signals incident on the receivers.

At step 240, the temperature sensor or control circuitry within device 10 may calculate the ambient temperature based on the phase differences. As previously discussed, a relationship between the phase differences and temperature may be calculated based on the Equation 1 and known properties of the transmitted and received signals. In this way, the ultrasonic temperature sensor may be used to measure ambient temperature.

Although ultrasonic temperature sensors have been described as measuring ambient temperatures by measuring the speed of sound through air, this is merely illustrative. In general, ultrasonic temperature sensors, such as temperature sensors 120, may be used to measure the temperature of any medium, such as water, other fluid, or other material outside of the electronic device (such as glass). In these alternative implementations, temperature sensors 120 may be formed in an interior of the electronic device (such as in cavity 30) or external to the electronic device, such as on a surface of a housing of the electronic device (such as housing 12).

As described above, one aspect of the present technology is the gathering and use of information such as information from input-output devices. The present disclosure contemplates that in some instances, data may be gathered that includes personal information data that uniquely identifies or can be used to contact or locate a specific person. Such personal information data can include demographic data, location-based data, telephone numbers, email addresses, twitter ID's, home addresses, data or records relating to a user's health or level of fitness (e.g., vital signs measurements, medication information, exercise information), date of birth, username, password, biometric information, or any other identifying or personal information.

The present disclosure recognizes that the use of such personal information, in the present technology, can be used to the benefit of users. For example, the personal information data can be used to deliver targeted content that is of greater interest to the user. Accordingly, use of such personal information data enables users to calculated control of the delivered content. Further, other uses for personal information data that benefit the user are also contemplated by the present disclosure. For instance, health and fitness data may be used to provide insights into a user's general wellness, or may be used as positive feedback to individuals using technology to pursue wellness goals.

The present disclosure contemplates that the entities responsible for the collection, analysis, disclosure, transfer, storage, or other use of such personal information data will comply with well-established privacy policies and/or privacy practices. In particular, such entities should implement and consistently use privacy policies and practices that are generally recognized as meeting or exceeding industry or governmental requirements for maintaining personal information data private and secure. Such policies should be easily accessible by users, and should be updated as the collection and/or use of data changes. Personal information from users should be collected for legitimate and reasonable uses of the entity and not shared or sold outside of those legitimate uses. Further, such collection/sharing should occur after receiving the informed consent of the users. Additionally, such entities should consider taking any needed steps for safeguarding and securing access to such personal information data and ensuring that others with access to the personal information data adhere to their privacy policies and procedures. Further, such entities can subject themselves to evaluation by third parties to certify their adherence to widely accepted privacy policies and practices. In addition, policies and practices should be adapted for the particular types of personal information data being collected and/or accessed and adapted to applicable laws and standards, including jurisdiction-specific considerations. For instance, in the United States, collection of or access to certain health data may be governed by federal and/or state laws, such as the Health Insurance Portability and Accountability Act (HIPAA), whereas health data in other countries may be subject to other regulations and policies and should be handled accordingly. Hence different privacy practices should be maintained for different personal data types in each country.

Despite the foregoing, the present disclosure also contemplates embodiments in which users selectively block the use of, or access to, personal information data. That is, the present disclosure contemplates that hardware and/or software elements can be provided to prevent or block access to such personal information data. For example, the present technology can be configured to allow users to select to "opt in" or "opt out" of participation in the collection of personal information data during registration for services or anytime thereafter. In another example, users can select not to provide certain types of user data. In yet another example, users can select to limit the length of time user-specific data is maintained. In addition to providing "opt in" and "opt out" options, the present disclosure contemplates providing notifications relating to the access or use of personal information. For instance, a user may be notified upon downloading an application ("app") that their personal information data will be accessed and then reminded again just before personal information data is accessed by the app.

Moreover, it is the intent of the present disclosure that personal information data should be managed and handled in a way to minimize risks of unintentional or unauthorized access or use. Risk can be minimized by limiting the collection of data and deleting data once it is no longer needed. In addition, and when applicable, including in certain health related applications, data de-identification can be used to protect a user's privacy. De-identification may be facilitated, when appropriate, by removing specific identifiers (e.g., date of birth, etc.), controlling the amount or specificity of data stored (e.g., collecting location data at a city level rather than at an address level), controlling how data is stored (e.g., aggregating data across users), and/or other methods.

Therefore, although the present disclosure broadly covers use of information that may include personal information data to implement one or more various disclosed embodiments, the present disclosure also contemplates that the various embodiments can also be implemented without the need for accessing personal information data. That is, the various embodiments of the present technology are not rendered inoperable due to the lack of all or a portion of such personal information data.

In accordance with an embodiment, an electronic device is provided that includes a housing, a display in the housing and a temperature sensor in the housing, the temperature sensor includes an ultrasonic transmitter and an ultrasonic receiver.

In accordance with another embodiment, the ultrasonic transmitter is configured to emit signals with different ultrasonic frequencies, the electronic device further includes control circuitry configured to determine an ambient temperature based on a phase difference between the different ultrasonic frequencies received by the ultrasonic receiver.

In accordance with another embodiment, the ultrasonic transmitter and the ultrasonic receiver are micro-electromechanical system sensors.

In accordance with another embodiment, the micro-electromechanical system sensors include arrays of piezoelectric micromachined ultrasound transducers.

In accordance with another embodiment, the piezoelectric micromachined ultrasound transducers are formed on complementary metal-oxide semiconductors.

In accordance with another embodiment, the ultrasonic transmitter is one of at least three ultrasonic transmitters and the ultrasonic receiver is one of at least three ultrasonic receivers.

In accordance with another embodiment, each of the ultrasonic transmitters is configured to emit a signal with a different ultrasonic frequency, and each of the ultrasonic receivers is configured to receive the signals emitted by all of the ultrasonic transmitters.

In accordance with another embodiment, the electronic device includes control circuitry configured to determine an ambient temperature based on a phase difference between the different ultrasonic frequencies received by the ultrasonic receivers.

In accordance with another embodiment, the housing has a cavity, and the temperature sensor is mounted in the cavity.

In accordance with another embodiment, the electronic device includes a screen covering the temperature sensor in the cavity.

In accordance with another embodiment, the cavity is a speaker port and the screen is a speaker grille.

In accordance with another embodiment, the ultrasonic transmitter and the ultrasonic receiver are separated by a gap between 10 mm and 15 mm.

In accordance with another embodiment, the ultrasonic transmitter is configured to emit signals with frequencies between 1 MHz and 3 MHz.

In accordance with an embodiment, an electronic device is provided that includes a housing, a temperature sensor in the housing, the temperature sensor includes a plurality of piezoelectric micromachined ultrasound transducers that are configured to transmit and receive ultrasonic signals and control circuitry configured to determine an ambient temperature based on a phase difference between the received ultrasonic signals.

In accordance with another embodiment, each of the piezoelectric micromachined ultrasound transducers is configured to transmit and receive the ultrasonic signals.

In accordance with another embodiment, the electronic device includes a structure within the housing, the piezoelectric micromachined ultrasound transducers are configured to receive ultrasonic signals that have reflected off of the structure.

In accordance with another embodiment, the piezoelectric micromachined ultrasound transducers are formed in an array, and each of the piezoelectric micromachined ultrasound transducers is configured to emit a different ultrasonic frequency.

In accordance with another embodiment, the housing includes a cavity and the temperature sensor is formed in the cavity, the electronic device further includes an acoustic filter covering the temperature sensor and the cavity.

In accordance with an embodiment, an electronic device is provided that includes a housing, a display in the housing, a temperature sensor includes an ultrasonic transmitter and an ultrasonic receiver, the ultrasonic transmitter is configured to emit signals with different ultrasonic frequencies that are received by the ultrasonic receiver and control circuitry in the housing that is configured to determine an ambient temperature based on a phase difference between the received signals.

In accordance with another embodiment, the ultrasonic transmitter and the ultrasonic receiver include arrays of piezoelectric micromachined ultrasound transducer arrays, and each of the piezoelectric micromachined ultrasound transducers arrays include piezoelectric micromachined ultrasound transducers that detect different ultrasonic frequencies.

The foregoing is illustrative and various modifications can be made to the described embodiments. The foregoing embodiments may be implemented individually or in any combination.

Exemplary electronic devices are set out in the following items.

1. An electronic device, comprising:

 a housing;
 a display in the housing; and
 a temperature sensor in the housing, wherein the temperature sensor comprises an ultrasonic transmitter and an ultrasonic receiver.

2. The electronic device defined in item 1, wherein the ultrasonic transmitter is configured to emit signals with different ultrasonic frequencies, the electronic device further comprising:
control circuitry configured to determine an ambient temperature based on a phase difference between the different ultrasonic frequencies received by the ultrasonic receiver.

3. The electronic device defined in item 2, wherein the ultrasonic transmitter and the ultrasonic receiver are micro-electromechanical system sensors.

4. The electronic device defined in item 3, wherein the micro-electromechanical system sensors comprise arrays of piezoelectric micromachined ultrasound transducers.

5. The electronic device defined in item 4, wherein the piezoelectric micromachined ultrasound transducers are formed on complementary metal-oxide semiconductors.

6. The electronic device defined in item 1, wherein the ultrasonic transmitter is one of at least three ultrasonic transmitters and wherein the ultrasonic receiver is one of at least three ultrasonic receivers.

7. The electronic device defined in item 6, wherein each of the ultrasonic transmitters is configured to emit a signal with a different ultrasonic frequency, and wherein each of the ultrasonic receivers is configured to receive the signals emitted by all of the ultrasonic transmitters.

8. The electronic device defined in item 7, further comprising:
control circuitry configured to determine an ambient temperature based on a phase difference between the different ultrasonic frequencies received by the ultrasonic receivers.

9. The electronic device defined in item 1, wherein the housing has a cavity, and the temperature sensor is mounted in the cavity.

10. The electronic device defined in item 9, further comprising:
a screen covering the temperature sensor in the cavity.

11. The electronic device defined in item 10, wherein the cavity is a speaker port and the screen is a speaker grille.

12. The electronic device defined in item 1, wherein the ultrasonic transmitter and the ultrasonic receiver are separated by a gap between 10 mm and 15 mm.

13. The electronic device defined in item 12, wherein the ultrasonic transmitter is configured to emit signals with frequencies between 1 MHz and 3 MHz.

14. An electronic device, comprising:

 a housing;
 a temperature sensor in the housing, wherein the temperature sensor comprises a plurality of piezoelectric micromachined ultrasound transducers that are configured to transmit and receive ultrasonic signals; and control circuitry configured to determine an ambient temperature based on a phase difference between the received ultrasonic signals.

15. The electronic device defined in item 14, wherein each of the piezoelectric micromachined ultrasound transducers is configured to transmit and receive the ultrasonic signals.

16. The electronic device defined in item 14, further comprises:
a structure within the housing, wherein the piezoelectric micromachined ultrasound transducers are configured to receive ultrasonic signals that have reflected off of the structure.

17. The electronic device defined in item 14, wherein the piezoelectric micromachined ultrasound transducers are formed in an array, and wherein each of the piezoelectric micromachined ultrasound transducers is configured to emit a different ultrasonic frequency.

18. The electronic device defined in item 14, wherein the housing comprises a cavity and wherein the temperature sensor is formed in the cavity, the electronic device further comprising:
an acoustic filter covering the temperature sensor and the cavity.

19. An electronic device, comprising:

a housing;
a display in the housing;
a temperature sensor comprising an ultrasonic transmitter and an ultrasonic receiver, wherein the ultrasonic transmitter is configured to emit signals with different ultrasonic frequencies that are received by the ultrasonic receiver; and
control circuitry in the housing that is configured to determine an ambient temperature based on a phase difference between the received signals.

20. The electronic device defined in item 1, wherein the ultrasonic transmitter and the ultrasonic receiver comprise arrays of piezoelectric micromachined ultrasound transducer arrays, and wherein each of the piezoelectric micromachined ultrasound transducers arrays comprises piezoelectric micromachined ultrasound transducers that detect different ultrasonic frequencies.

21. The electronic device defined in item 20, further comprising:
a structure within the housing, wherein the piezoelectric micromachined ultrasound transducers are configured to receive ultrasonic signals that have reflected off of the structure.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated.

**Claims**

1.  An electronic device, comprising:

a housing;
a display in the housing; and
a temperature sensor in the housing, wherein the temperature sensor comprises an ultrasonic transmitter and an ultrasonic receiver.

2.  The electronic device defined in claim 1, wherein the ultrasonic transmitter is configured to emit signals with different ultrasonic frequencies, the electronic device further comprising:
control circuitry configured to determine an ambient temperature based on a phase difference between the different ultrasonic frequencies received by the ultrasonic receiver.

3. The electronic device defined in claim 2, wherein the ultrasonic transmitter and the ultrasonic receiver are micro-electromechanical system sensors.

4. The electronic device defined in claim 3, wherein the micro-electromechanical system sensors comprise arrays of piezoelectric micromachined ultrasound transducers.

5. The electronic device defined in claim 4, wherein the piezoelectric micromachined ultrasound transducers are formed on complementary metal-oxide semiconductors.

6. The electronic device defined in any of the preceding claims, wherein the ultrasonic transmitter is one of at least three ultrasonic transmitters and wherein the ultrasonic receiver is one of at least three ultrasonic receivers.

7. The electronic device defined in claim 6, wherein each of the ultrasonic transmitters is configured to emit a signal with a different ultrasonic frequency, and wherein each of the ultrasonic receivers is configured to receive the signals emitted by all of the ultrasonic transmitters.

8. The electronic device defined in claim 7, further comprising:
control circuitry configured to determine an ambient temperature based on a phase difference between the different ultrasonic frequencies received by the ultrasonic receivers.

9. The electronic device defined in any of the preceding claims, wherein the housing has a cavity, and the temperature sensor is mounted in the cavity.

10. The electronic device defined in claim 9, further comprising:
a screen covering the temperature sensor in the cavity.

11. The electronic device defined in claim 10, wherein the cavity is a speaker port and the screen is a speaker grille.

12. The electronic device defined in any of the preceding claims, wherein the ultrasonic transmitter and the ultrasonic receiver are separated by a gap between 10 mm and 15 mm.

13. The electronic device defined in claim 12, wherein the ultrasonic transmitter is configured to emit signals with frequencies between 1 MHz and 3 MHz.

14. The electronic device defined in any of the preceding claims, wherein the ultrasonic transmitter and the ultrasonic receiver comprise arrays of piezoelectric micromachined ultrasound transducer arrays, and wherein each of the piezoelectric micromachined ultrasound transducers arrays comprises piezoelectric micromachined ultrasound transducers that detect different ultrasonic frequencies.

15. The electronic device defined in claim 14, further comprising:
a structure within the housing, wherein the piezoelectric micromachined ultrasound transducers are configured to receive ultrasonic signals that have reflected off of the structure.

**FIG. 1**

**FIG. 2**

**FIG. 3**

10

12

120

13    15

**FIG. 4A**

10

12-1                    12-2

15-1

20

15-2

20

**FIG. 4B**

FIG. 5

**FIG. 6**

$$d = \left(n_1 + \frac{\Phi_1}{2\pi}\right) \cdot \lambda_1 = \left(n_2 + \frac{\Phi_2}{2\pi}\right) \cdot \lambda_2$$

*FIG. 7*

**FIG. 8A**

**FIG. 8B**

**FIG. 9**

PHASE DIFFERENCE — TEMPERATURE — 34

*FIG. 10*

**FIG. 11**

**FIG. 12**

EMIT MULTIPLE SIGNALS AT ULTRASONIC FREQUENCIES — 210

RECEIVE THE SIGNALS WITH AT LEAST ONE ULTRASONIC SENSOR — 220

MEASURE A PHASE DIFFERENCE BETWEEN THE RECEIVED FREQUENCIES — 230

CALCULATE THE AMBIENT TEMPERATURE BASED ON THE PHASE DIFFERENCES — 240

**FIG. 13**

Europäisches
Patentamt

European
Patent Office

Office européen
des brevets

# EUROPEAN SEARCH REPORT

Application Number

EP 23 18 0597

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/293499 A1 (KEAL WILLIAM KERRY [US]) 26 September 2019 (2019-09-26) * abstract * * figures 1A-7 * * paragraphs [0030] – [0086] * ----- | 1-15 | INV. G01K11/24 H04M1/72403 |
| X | GB 2 578 642 A (SCB ASS LTD [GB]) 20 May 2020 (2020-05-20) * abstract * * figures 1-5 * * page 4, line 17 – page 9, line 7 * ----- | 1,3-15 | |
| A | CHEN XUYING ET AL: "High-Accuracy Ultrasonic Rangefinders via pMUTs Arrays Using Multi-Frequency Continuous Waves", JOURNAL OF MICROELECTROMECHANICAL SYSTEMS, IEEE SERVICE CENTER, US, vol. 28, no. 4, 1 August 2019 (2019-08-01) , pages 634-642, XP011737647, ISSN: 1057-7157, DOI: 10.1109/JMEMS.2019.2912869 [retrieved on 2019-07-30] * the whole document * ----- | 1-15 | TECHNICAL FIELDS SEARCHED (IPC) G01K G01P H04M |

The present search report has been drawn up for all claims

| Place of search | Date of completion of the search | Examiner |
|---|---|---|
| The Hague | 29 November 2023 | Totò, Nicola |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 18 0597**

This annex lists the patent family members relating to the patent documents cited in the above-mentioned European search report.
The members are as contained in the European Patent Office EDP file on
The European Patent Office is in no way liable for these particulars which are merely given for the purpose of information.

**29-11-2023**

| Patent document cited in search report | | Publication date | Patent family member(s) | | Publication date |
|---|---|---|---|---|---|
| US 2019293499 | A1 | 26-09-2019 | US 2018273374 A1 | | 27-09-2018 |
| | | | US 2019293499 A1 | | 26-09-2019 |
| GB 2578642 | A | 20-05-2020 | NONE | | |

EPO FORM P0459

For more details about this annex : see Official Journal of the European Patent Office, No. 12/82